# DEMANDE DE BREVET EUROPEEN

(11) **EP 3 654 369 A1**
(43) Date de publication de la demande: **20.05.2020**
(21) Numéro de dépôt: 19207827.7
(22) Date de dépôt: 07.11.2019
(51) Int. Cl.: H01L 21/67, H01L 21/677, H01L 21/687

(54) **DISPOSITIF DE TRANSPORT POUR PLAQUES DÉSTINÉES À FORMER DES COMPOSANTS ÉLÉCTRONIQUES**

(30) Priorité: 16.11.2018 FR 1860608
(71) Demandeur: Commissariat à l'Énergie Atomique et aux Énergies Alternatives, 75015 Paris (FR)
(72) Inventeur: METRAL, Frédéric, 38054 GRENOBLE Cedex 09 (FR); JERONIMO, Pedro, 38054 GRENOBLE Cedex 09 (FR)
(74) Mandataire: GIE Innovation Competence Group

(57) **Abrégé**

Le dispositif (100) de transport pour plaques (200) destinées à former des composants électroniques comporte un plateau (101), le plateau (101) comportant des logements (102) pour les plaques (200). Ce dispositif (100) de transport comporte un dispositif (104) de détection de proximité d'objet par rapport au plateau (101), ledit dispositif (104) de détection étant configuré pour détecter la proximité d'un objet lorsque l'objet exerce une force sur le dispositif (104) de détection.

## Description

### Domaine technique de l'invention

Le domaine technique de l'invention concerne la fabrication de composants électroniques comme par exemple des cellules photovoltaïques.

### Etat de la technique

Il est connu lors de la fabrication de cellules photovoltaïques de déposer une couche d'oxyde transparent conducteur (TCO pour l'anglais « transparent conductive oxide ») par un procédé de dépôt par pulvérisation cathodique (PVD pour l'anglais « physical vapor déposition »). Pour réaliser un tel dépôt, il est connu de placer des plaques destinées à former les cellules photovoltaïques sur un plateau de transport, puis de faire passer ce plateau au travers d'une chambre de dépôt d'un dispositif de dépôt par pulvérisation cathodique. Le principe du dépôt par pulvérisation cathodique est le suivant : une cible constituée du matériau à déposer est bombardée par des ions d'argon, ces ions arrachent les atomes de la cible grâce à leur énergie cinétique d'où il résulte une pulvérisation de ces atomes ; les atomes pulvérisés se déposent sur toutes les zones en regard de la cible et notamment sur les plaques présentes dans la chambre de dépôt. Les parois de la chambre de dépôt et toutes les pièces situées au niveau de ces parois sont exposées à ce dépôt ; à partir d'une certaine épaisseur, ce dépôt se décolle et devient une source de particules qui se déposent partout dans la chambre de dépôt ainsi que sur les plaques au cours du procédé de dépôt. Il faut donc régulièrement nettoyer la chambre de dépôt et toutes les pièces situées dans cette chambre de dépôt. Cependant une telle tâche de nettoyage est fastidieuse voire impossible tant la taille et la complexité de la chambre de dépôt est grande. Afin de rendre possible un tel nettoyage de la chambre de dépôt, il est placé dans cette chambre de dépôt des d'écrans de protection des pièces de la chambre de dépôt et de ses parois. Ces écrans de protection sont facilement démontables et nettoyables. En cas de besoin, ces écrans de protection sont démontés pour nettoyage, un jeu supplémentaire d'écrans de protection neufs ou propres permet de rendre cette opération quasiment transparente en terme de disponibilité du dispositif de dépôt. Cependant, les dépôts successifs sur les écrans de protection entraînent une déformation de ceux-ci, déformation qui peut provoquer des frottement des écrans de protection avec le plateau lors de son passage dans la chambre de dépôt. Ce frottement peut entraîner un dépôt de poudre sur les plaques transportées par le plateau. Un tel dépôt pollue les plaques, et est néfaste pour le fonctionnement ultérieur des cellules photovoltaïques. Il existe donc un besoin de trouver une solution pour éviter le frottement des écrans de protection contre le plateau pour limiter la pollution des plaques.

### Objet de l'invention

L'invention a pour but d'éviter le frottement d'un objet avec un plateau permettant d'assurer le transport de plaques destinées à former des composants électroniques.

A cet effet, l'invention est relative à un dispositif de transport pour plaques destinées à former des composants électroniques, ledit dispositif de transport comportant un plateau, le plateau comportant des logements pour les plaques, ce dispositif de transport étant caractérisé en ce qu'il comporte un dispositif de détection de proximité d'objet par rapport au plateau, ledit dispositif de détection étant configuré pour détecter la proximité d'un objet lorsque l'objet exerce une force sur le dispositif de détection.

Grâce à au dispositif de détection de proximité, il est possible de détecter l'objet avant que ce dernier ne vienne au contact du plateau ou de plaques transportées par ce plateau. Une telle détection rend par exemple possible d'arrêter le déplacement du plateau pour éviter le contact décrit ci-dessus, notamment avant que l'objet ne fasse obstacle au déplacement du plateau.

Le dispositif de transport peut comporter une ou plusieurs des caractéristiques suivantes :
- le dispositif de détection comporte un organe mobile configuré pour se déplacer lorsque l'objet exerce ladite force sur l'organe mobile, et le dispositif de détection est configuré pour détecter un déplacement de l'organe mobile représentatif d'une détection de la proximité de l'objet par rapport au plateau ;
- le dispositif de détection comporte une cavité à géométrie variable et un élément de mesure d'une distance, le dispositif de détection étant configuré pour qu'une modification la géométrie de la cavité, provoquée lorsque l'objet exerce la force sur le dispositif de détection, induit une modification de la distance ;

- l'élément de mesure est configuré pour réaliser une mesure optique de la distance ;
- l'élément de mesure est un télémètre laser ;
- le dispositif de détection est configuré de telle sorte que le déplacement de l'organe mobile provoque la modification de la géométrie de la cavité ;
- le dispositif de détection comporte une pièce mobile, la pièce mobile et l'organe mobile délimitant la cavité à géométrie variable ;
- le dispositif de détection comporte un dispositif de rappel sollicitant la pièce mobile et l'organe mobile chacun vers une position associée à une configuration déployée de la cavité, et l'organe mobile et la pièce mobile sont configurés de sorte à se rabattre vers le plateau par glissement de l'organe mobile sur la pièce mobile lorsque l'organe mobile est mis en mouvement par l'objet ;
- le dispositif de détection comporte une butée de limitation du déplacement de l'organe mobile ;
- le plateau comporte un bord, et le dispositif de détection s'étend le long de ce bord, et de préférence tout du long de ce bord ;
- le dispositif de transport comporte un dispositif de communication configuré pour transmettre un message lorsque le dispositif de détection détecte la proximité de l'objet par rapport au plateau.

L'invention est aussi relative à une installation pour traiter des plaques, cette installation comportant :
- un dispositif de transport pour plaques tel que décrit,
- un dispositif à passage comportant une chambre de traitement des plaques pour traiter les plaques lors du passage du dispositif de transport au travers du dispositif à passage.

De préférence, l'installation est telle que :
- le dispositif à passage comporte un automate de commande du déplacement du dispositif de transport dans le dispositif à passage,
- le dispositif de transport est configuré pour transmettre un message à l'automate de commande en cas de détection, par le dispositif de détection, de la proximité d'un objet dans le dispositif à passage.

Avantageusement, la chambre du dispositif à passage est une chambre de dépôt d'un matériau par pulvérisation cathodique.

L'invention est aussi relative à un procédé de traitement de plaques destinées à former des composants électroniques, les plaques étant logées dans les logements d'un dispositif de transport tel que décrit, ledit procédé de traitement comportant :
- une étape de déplacement du dispositif de transport dans un dispositif à passage comportant une chambre de traitement des plaques,
- une étape de détection de la proximité d'un objet par le dispositif de détection au cours de l'étape de déplacement.

Le procédé de traitement peut comporter, après détection de la proximité de l'objet par le dispositif de détection, une étape d'arrêt de l'étape de déplacement du dispositif de transport.

Avantageusement, dans le cadre du procédé de traitement, au cours de l'étape de déplacement, l'objet vient exercer une force sur un organe mobile du dispositif de transport d'où il résulte un déplacement de l'organe mobile modifiant une distance mesurée par un élément de mesure du dispositif de détection, et le procédé de traitement comporte une étape de traitement de la distance mesurée telle que :
- si la distance mesurée est supérieure ou égale à un premier seuil et est strictement inférieure à une valeur de référence représentative d'une absence d'objet en contact avec l'organe mobile, alors l'étape de détection détecte la proximité de l'objet et la mise en œuvre de l'étape de déplacement continue,
- si la distance mesurée est inférieure ou égale à un deuxième seuil, alors le déplacement du dispositif de transport est stoppé, le deuxième seuil étant strictement inférieur au premier seuil.

D'autres avantages et caractéristiques pourront ressortir clairement de la description qui va suivre.

### Description sommaire des dessins

L'invention sera mieux comprise à la lecture de la description qui va suivre, donnée uniquement à titre d'exemple non limitatif et faite en se référant aux dessins annexés dans lesquels :
- La figure 1 représente une vue de dessus d'un dispositif de transport selon un mode de réalisation de l'invention ;
- La figure 2 est une vue en coupe partielle selon la coupe A-A de la figure 1 ;
- La figure 3 est une vue en perspective partielle centrée sur un dispositif de détection de proximité selon un mode de réalisation particulier de l'invention ;
- La figure 4 illustre une vue en perspective partielle centrée sur le dispositif de détection de proximité pour lequel un élément de protection visible en figure 3 a été retiré pour visualiser une cavité à géométrie variable adoptant une configuration déployée ;
- La figure 5 est une vue de côté montrant une configuration pour laquelle un objet est en contact avec le dispositif de détection d'où il résulte que la géométrie de la cavité de la figure 4 est modifiée ;
- La figure 6 illustre schématiquement, et vue de côté une selon une coupe, une installation pour le traitement de plaques selon un mode particulier de réalisation de l'invention ;
- La figure 7 illustre une vue de dessus du dispositif de transport selon une variante à plusieurs dispositifs de détection de proximité ;
- La figure 8 illustre une vue partielle de côté du dispositif de transport montrant une configuration de repli de la cavité ;
- La figure 9 illustre schématiquement des étapes d'un procédé de traitement selon une réalisation de l'invention.

Dans ces figures, les mêmes références sont utilisées pour désigner les mêmes éléments.

### Description détaillée

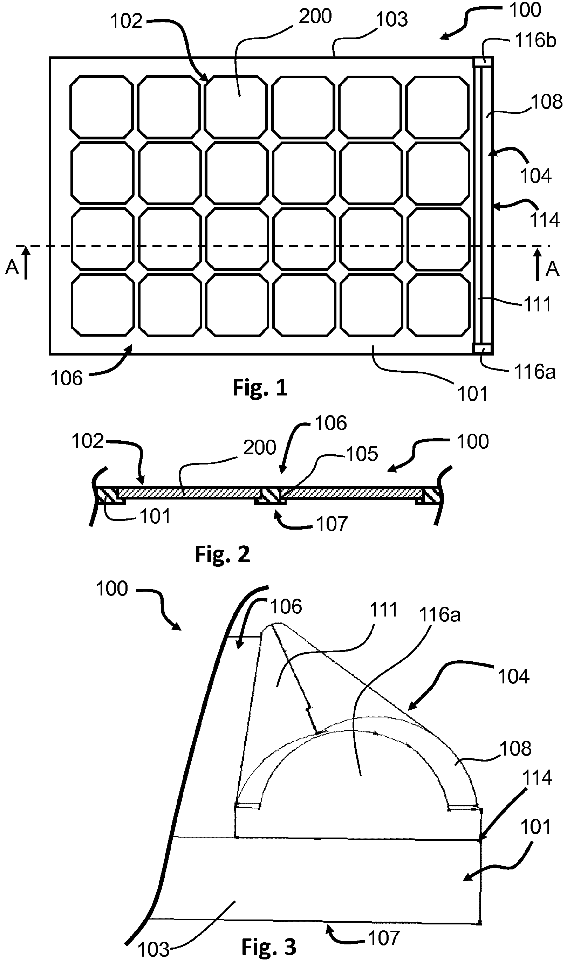

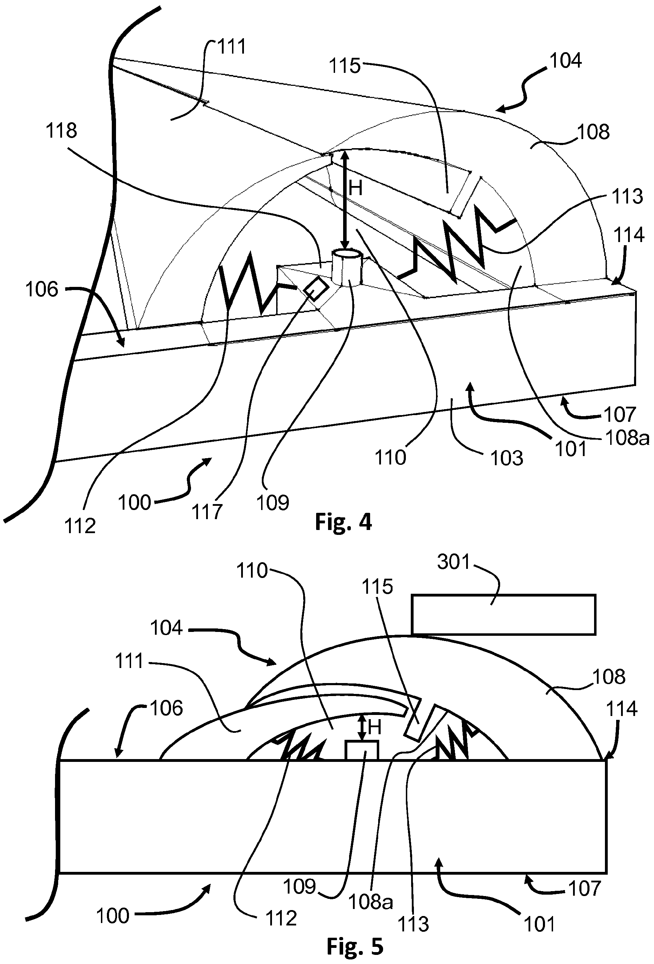

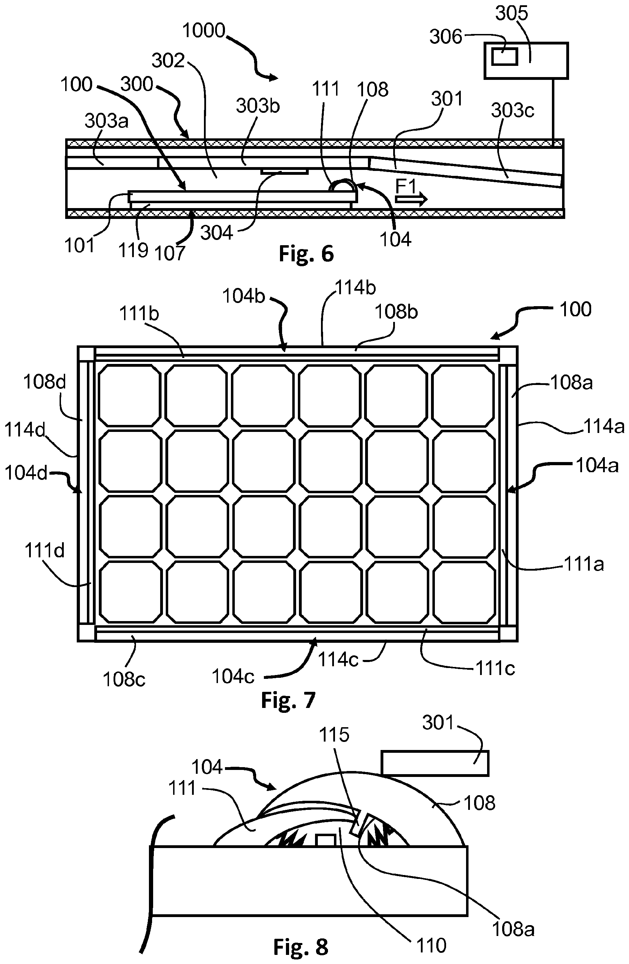

Un dispositif 100 de transport pour plaques 200 destinées à former des composants électroniques décrit ci-après, et visible à titre d'exemple en figures 1 à 6, est notamment destiné à se déplacer dans un dispositif 300 à passage (figure 6). Le dispositif 100 de transport est adapté pour détecter un objet 301 (figures 5 et 6) avant que ce dernier ne vienne au contact d'un plateau 101 (« tray » en langue anglaise) de ce dispositif 100 de transport ou ne vienne faire obstacle au déplacement du plateau 101, en particulier lorsque le dispositif 100 de transport est déplacé dans le dispositif 300 à passage. Le plateau 101 est aussi appelé plateau de support des plaques 200. En ce sens, l'objet 301 décrit peut être considéré comme un obstacle si ce dernier est susceptible de venir au contact du plateau 101 lors du déplacement du dispositif 100 de transport.

De préférence, les composants électroniques sont des cellules photovoltaïques obtenues après fonctionnalisation des plaques 200, notamment en leur ajoutant au moins une couche d'un matériau spécifique et/ou des éléments adaptés connus de l'homme du métier et qui ne seront pas décrits en détails. En ce sens, chaque plaque 200 est, de préférence, destinée à former un composant électronique.

Dans la présente description, le dispositif 300 à passage, illustré à titre d'exemple en figure 6, est un dispositif permettant de traiter les plaques 200 portées par le dispositif 100 de transport. Le dispositif 300 est dit « à passage » car il permet de traiter les plaques 200 lorsque le dispositif 100 de transport défile/passe dans le dispositif 300 à passage. Le dispositif 300 à passage peut comporter une chambre 302 de traitement des plaques 200 pour traiter les plaques 200 lors du passage du dispositif 100 de transport au travers du dispositif 300 à passage, c'est-à-dire dans la chambre 302 de traitement.

Par « traitement des plaques », il est entendu que les plaques 200 peuvent être modifiées, par exemple en ajoutant sur chacune des plaques 200 une couche d'un matériau en vue d'assurer une fonction. Par exemple, cette couche est une couche d'oxyde transparent conducteur (TCO), comme par exemple une couche d'oxyde d'indium-étain (ITO), et dont la fonction est de former une électrode de cellule photovoltaïque.

Ainsi, la chambre 302 de traitement peut être une chambre de dépôt, notamment par pulvérisation cathodique, du matériau susmentionné. Une telle chambre 302 de traitement peut comporter des écrans de protection 303a, 303b, 303c, ainsi qu'une cible 304 constituée du matériau à déposer. La cible 304 est à bombarder par des ions, par exemple d'argon, pour pulvériser le matériau de cette cible 304 sur les plaques 200 lors du passage, dans la chambre 302 de traitement, du dispositif 100 de transport transportant les plaques 200 (figure 6). Sur l'exemple représenté en figure 6, l'écran 303c de protection adopte une position anormale de sorte à ce qu'il forme l'objet 301 qui viendra au contact du plateau 101 si le déplacement du dispositif 100 de transport selon la flèche F1 n'est pas stoppé.

Ainsi, l'invention est relative au dispositif 100 de transport comportant le plateau 101. Le plateau 101 comporte des logements 102, aussi appelés alvéoles, pour les plaques 200 (figures 1 et 2). Le plateau 101 peut comporter un cadre 103 entourant les logements 102 (figure 1). Par ailleurs, ce dispositif 100 de transport comporte un dispositif 104 de détection de proximité d'un objet 301, ou d'objet, par rapport au plateau 101. Le dispositif 104 de détection est configuré pour détecter la proximité de l'objet 301 lorsque l'objet 301 exerce une force sur le dispositif 104 de détection. Ceci permet de détecter l'objet 301 avant qu'il ne vienne au contact du plateau 101 et/ou d'au moins une des plaques 200 portées par le plateau 101, et de prendre, le cas échéant, les dispositions nécessaires pour éviter un frottement entre le plateau 101 et l'objet 301 et/ou entre au moins une des plaques 200 et l'objet 301.

Notamment, la force que vient exercer l'objet 301 sur le dispositif 104 de détection est un appui réalisé par l'objet 301 sur le dispositif 104 de détection. Ainsi, le dispositif 104 de détection de proximité est, de préférence, un dispositif 104 de détection de proximité par contact dans le sens où le contact/l'appui de l'objet 301 sur ce dispositif 104 de détection permet de détecter la proximité de l'objet 301 par rapport au plateau 101.

En particulier, lorsque les plaques 200 sont logées dans les logements 102, les plaques 200 logées sont entourées par le cadre 103 de telle sorte que les plaques 200 sont entièrement disposées entre deux faces opposées du cadre 103.

Sur la figure 1, il est représenté le dispositif 100 de transport à 24 logements 102. Bien entendu ceci n'est qu'un exemple, le nombre de logements 102 peut être adapté en fonction du nombre de plaques 200 à traiter, de la taille des plaques à traiter et des dimensions du dispositif 300 à passage, notamment de sa chambre 302 de traitement, dans lequel le dispositif 100 de transport va être amené à passer.

La figure 2 permet d'illustrer comment les plaques 200 sont portées par le dispositif 100 de transport. En particulier, les logements 102 sont formés par des trous traversant le plateau 101. Les logements 102 comportent notamment chacun un décrochement 105 sur lequel repose un pourtour d'une plaque 200 correspondante.

Notamment, le plateau 101 comporte une première face 106 et une deuxième face 107 opposées (figures 1 à 5), en particulier selon l'épaisseur du plateau 101. Lors de l'utilisation du dispositif 100 de transport, la première face 106 est une face supérieure, et la deuxième face 107 est une face inférieure. Dans le cadre du passage du dispositif 100 de transport au travers du dispositif 300 à passage, on cherchera à éviter tout contact de l'objet 301 avec le plateau 101 à sa face supérieure 106. En ce sens, le dispositif 104 de détection est préférentiellement agencé à la face supérieure 106 du plateau 101. Selon une autre formulation, le dispositif 104 de détection s'étend en saillie par rapport au plateau 101, ceci lui permettant d'entrer en contact avec l'objet 301 en vue de le détecter avant que ce dernier ne vienne en contact avec le plateau 101 (figure 5) à sa face supérieure. Ainsi, de préférence, le dispositif 104 de détection est monté sur une face du plateau 101, notamment sa face supérieure 106, pour laquelle un contact avec l'objet 301 est à éviter.

Selon une réalisation, le dispositif 104 de détection comporte un organe 108 mobile (figures 1, et 3 à 6) configuré pour se déplacer lorsque l'objet 301 exerce la force évoquée ci-avant sur l'organe 108 mobile (figure 5), et le dispositif 104 de détection est configuré pour détecter un déplacement de l'organe 108 mobile représentatif d'une détection de la proximité de l'objet 301 par rapport au plateau 101. Cette réalisation est avantageuse dans le sens où elle permet une réalisation simple de la détection par contact mécanique notamment avec un organe 108 mobile dont le déplacement peut être déterminé par exemple par mesure.

Il résulte du paragraphe précédent qu'il existe un besoin de mesurer un paramètre variant en fonction du déplacement de l'organe 108 mobile afin de permettre la détection de la proximité de l'objet 301 en analysant ce déplacement de l'organe 108 mobile. Pour répondre à ce besoin, le dispositif 104 de détection peut comporter un élément 109 de mesure (visible en figures 4 et 5) par exemple fixé à un support 118 appartenant au plateau 101. Cet élément 109 de mesure peut être configuré pour réaliser une mesure (de préférence optique) d'une distance, notamment entre l'élément 109 de mesure et une partie du dispositif 104 de détection, variant en fonction du déplacement de l'organe 108 mobile. La mesure optique est préférée pour éviter des problèmes de mesure lors du passage du dispositif 100 de transport dans un environnement perturbé magnétiquement, comme c'est notamment le cas dans le dispositif 300 à passage permettant un dépôt par pulvérisation cathodique d'une couche sur les plaques 200 transportées par le dispositif 100 de transport.

Selon une réalisation particulière, le dispositif 104 de détection comporte une cavité 110 (figures 4 et 5) à géométrie variable et l'élément 109 de mesure permet de mesurer la distance H, notamment à l'intérieur de la cavité 110. De préférence, la distance H est ici une dimension de la cavité 110 telle que par exemple sa hauteur. Le dispositif 104 de détection est alors configuré pour qu'une modification de la géométrie de la cavité 110, provoquée lorsque l'objet 301 exerce la force (c'est-à-dire est en appui) sur le dispositif 104 de détection, induit une modification de la distance H, c'est-à-dire de la distance H que mesure l'élément 109 de mesure en particulier dans la cavité 110. Ici, la distance H entre l'élément 109 de mesure et la partie du dispositif 104 de détection est notamment telle que ladite partie du dispositif 104 de détection correspond à une zone d'une paroi de la cavité 110 située à distance du plateau 101. L'avantage d'une telle cavité 110 à géométrie variable est que ses dimensions varient en même temps que sa géométrie d'où il résulte qu'une mesure de distance peut aisément être représentative, le cas échéant, du déplacement de l'organe 108 mobile. Par ailleurs, une telle cavité 110 peut aussi assurer une protection de l'élément 109 de mesure : en effet si ce dernier mesure une distance à l'intérieur de la cavité 110, ou une dimension de la cavité 110, il est notamment protégé de l'objet 301 par la paroi de la cavité 110 qui assure aussi une protection relativement au dépôt de matériau, par exemple par pulvérisation, en évitant que le matériau ne se dépose sur l'élément 109 de mesure. La cavité 110 peut aussi assurer une protection aux poussières qui pourraient fausser les mesures de l'élément 109 de mesure. En ce sens, l'élément 109 de mesure est ici préférentiellement agencé dans la cavité 110 qui en permet la protection.

De préférence, la géométrie de la cavité 110 est dépendante de l'organe 108 mobile décrit ci-avant. En ce sens, le dispositif 104 de détection est notamment configuré de telle sorte que le déplacement de l'organe 108 mobile provoque la modification de la géométrie de la cavité 110. Dans ce cas, lorsque l'objet 301 appui suffisamment sur l'organe 108 mobile, cela permet de modifier la géométrie de la cavité 110 par déplacement de l'organe 108 mobile qui délimite une partie de la paroi de la cavité 110. Cette solution présente l'avantage d'être simple à mettre en œuvre, notamment en limitant le nombre d'éléments à déplacer mécaniquement pour faire varier la géométrie de la cavité 110, et présente aussi l'avantage de protéger l'élément 109 de mesure notamment du dépôt de matériau sur cet élément 109 de mesure.

Avantageusement, le dispositif 104 de détection comporte une pièce 111 mobile (figures 1 et 3 à 6), la pièce 111 mobile et l'organe 108 mobile délimitant la cavité 110 à géométrie variable. Ici, la pièce 111 mobile et l'organe 108 mobile forment la paroi de la cavité 110. L'utilisation de deux parties mobiles, la pièce 111 mobile et l'organe 108 mobile, pour délimiter et donc faire varier la géométrie de la cavité 110 est avantageuse car cela limite le nombre de pièces mécaniques en mouvement : le mécanisme est simple et présente moins de risques de se gripper lors de passages successifs du dispositif 100 de transport dans le dispositif 300 à passage. Ici, l'organe 108 mobile peut, lors de son déplacement, glisser sur la pièce 111 mobile entraînant ainsi un déplacement de la pièce 111 mobile d'où il résulte la modification de la géométrie de la cavité 110. Par exemple, en figure 4, la zone de la paroi de la cavité 110 permettant de mesurer la distance H est délimitée par une portion de l'organe 8 mobile, et en figure 5 cette zone de la paroi de la cavité 110 est délimitée par une portion de la pièce 111 mobile.

De préférence, afin de favoriser le glissement de l'organe 108 mobile sur la pièce 111 mobile et un glissement de l'objet 301 sur l'organe 108 mobile, l'organe 108 mobile et la pièce 111 mobile présentent chacun une forme arrondie convexe. La forme arrondie convexe de l'organe 108 mobile coopère avec l'objet 301 pour déplacer l'organe 108 mobile. La forme arrondie convexe de la pièce 111 mobile permet le glissement de l'organe 108 mobile sur la pièce 111 mobile. Autrement dit, les surfaces dite extérieures de l'organe 108 mobile et de la pièce 111 mobile, opposées à la cavité 110 délimitée à l'aide de surfaces dites intérieures de l'organe 108 mobile et de la pièce 111 mobile, sont convexes. Par ailleurs, la surface intérieure de l'organe 108 mobile comporte au moins une partie concave coopérant avec la surface extérieure convexe de la pièce 111 mobile pour permettre le déplacement de la pièce 111 mobile lorsque l'organe 108 mobile se déplace.

Il a été décrit ci-avant que le déplacement de l'organe 108 mobile et de la pièce 111 mobile pouvait faire varier la géométrie de la cavité 110 tout en protégeant l'élément 109 de mesure. La géométrie de la cavité 110 étant modifiée par un appui de l'objet 301 sur l'organe 108 mobile, il existe un besoin d'assurer le maintien de la cavité 110 dans un état représentatif d'une situation sans objet à proximité lorsqu'aucune force n'est exercée par l'objet 301 sur cet organe 108 mobile, et un besoin de remettre la cavité 110 dans cet état lorsque la force exercée par l'objet 301 sur l'organe 108 mobile cesse. En ce sens, pour répondre à ces besoins, le dispositif 104 de détection peut comporter un dispositif de rappel 112, 113 (figures 4 et 5) sollicitant la pièce 111 mobile et l'organe 108 mobile chacun vers une position associée à une configuration déployée de la cavité 110. Autrement dit, lorsque l'organe 108 mobile est dans sa position associée à la configuration déployée et que la pièce 111 mobile est dans sa position associée à la configuration déployée, alors la cavité 111 adopte cette configuration déployée. Par ailleurs, l'organe 108 mobile et la pièce 111 mobile sont configurés de sorte à se rabattre vers le plateau 101, notamment sur lequel ils sont montés à pivotement par exemple à l'aide d'un axe de pivotement fixé au plateau 101, par glissement de l'organe 108 mobile sur la pièce 111 mobile lorsque l'organe 108 mobile est mis en mouvement par l'objet 301, c'est-à-dire lorsque l'objet 301 appui sur l'organe 108 mobile.

Le dispositif 112, 113 de rappel décrit ci-dessus peut comporter deux ressorts 112, 113, notamment de compression, tendant à déplacer la pièce 111 mobile et l'organe 108 mobile vers des directions opposées. L'avantage de l'utilisation de ressorts est qu'il s'agit d'éléments peu coûteux et dont l'encrassement, en cas de passage du dispositif 100 de transport dans une chambre 302 de traitement, est limité. L'utilisation de ressorts permet aussi de limiter le nombre de pièces mécaniques utilisées dans le cadre du dispositif 104 de détection pour éviter l'encrassement du dispositif 104 de détection. Par ailleurs, le dispositif 112, 113 de rappel est notamment situé dans la cavité 110 qui protège ce dispositif 112, 113 de rappel à la manière de la protection évoquée de l'élément 109 de mesure. Par exemple, le ressort 112 relie le support 118 de l'élément 109 de mesure à la pièce 111 mobile, et le ressort 113 relie le support 118 de l'élément 109 de mesure à l'organe 108 mobile.

De préférence, le plateau 101, et notamment son cadre 103, comporte un bord 114 (visible en figures 1, 3, 4 et 5), aussi appelé bord d'insertion du dispositif 100 de transport dans le dispositif 300 à passage. Le dispositif 104 de détection s'étend le long de ce bord 114, et de préférence tout du long de ce bord 114. Notamment, ce bord 114 est un bord du cadre 103, et le dispositif 104 de détection est fixé sur ce bord, en particulier du côté de la face 106 supérieure. Ceci permet une détection de proximité d'objet efficace sur le chemin du dispositif 100 de transport dont l'avant selon le sens de déplacement du dispositif 100 de transport est formé par le bord 114 décrit ci-dessus.

L'organe 108 mobile est préférentiellement monté à pivotement, notamment sur plateau 101, et préférentiellement sur le bord 114 d'insertion. En ce sens, le dispositif 100 de transport est notamment destiné à se déplacer dans une direction sécante, notamment orthogonale, par rapport à l'axe de pivotement de l'organe 108 mobile pour détecter efficacement la proximité d'un objet correspondant. Il en va de même, le cas échéant pour la pièce 111 mobile qui est montée à pivotement au cadre 103 du côté du bord 114. Autrement dit, la mobilité de l'organe 108 mobile, et le cas échéant de la pièce 111 mobile, est conférée par une liaison pivot correspondante.

Si le dispositif 100 de transport est amené à être déplacé selon différentes directions relativement à son référentiel, plusieurs de ses bords peuvent être équipés chacun d'un dispositif de détection de proximité d'objet. Par exemple, sur la figure 7, le dispositif 100 de transport comporte quatre bords 114a, 114b 114c, 114d délimitant sa périphérie, et sur chacun de ces bords 114a, 114b 114c, 114d est monté un dispositif 104a, 104b, 104c, 104d de détection de proximité d'objet par exemple comportant chacun une pièce mobile 111a, 111b, 111c, 111d et un organe 108a, 108b, 108c, 108d mobile délimitant une cavité correspondante logeant un élément de mesure d'une distance correspondante.

Avantageusement, le dispositif 104 de détection comporte une butée 115 (par exemple visible sur les figures 4 et 5) de limitation du déplacement de l'organe 108 mobile. Une telle butée 115 est avantageuse dans le sens où elle permet de protéger le dispositif 104 de détection, notamment l'élément 109 de mesure en évitant qu'une partie du dispositif 104 de détection ne vienne en contact contre l'élément 109 de mesure. Selon la réalisation comportant l'organe 108 mobile et la pièce 111 mobile, la butée 115 s'étend d'une paroi 108a de l'organe 108 mobile (figures 4 et 5) participant à délimiter la paroi de la cavité 110 de telle sorte que lorsque l'objet 301 appui trop fortement sur l'organe 108 mobile, l'organe 8 mobile glisse sur la pièce 111 mobile jusqu'à ce que la pièce 111 mobile vienne en contact avec la butée 115 pour stopper le mouvement relatif entre la pièce 111 mobile et l'organe 108 mobile (figure 8) d'où il résulte que le dispositif 104 de détection présente une configuration de repli de sa cavité 110.

L'élément 109 de mesure est préférentiellement un télémètre laser. L'utilisation d'un télémètre laser présente l'avantage de mesurer la distance entre l'élément 109 de mesure et la partie correspondante du dispositif 104 de détection, le cas échéant la dimension de la cavité 110, de manière précise sans être perturbé par un champ magnétique par exemple d'une chambre 302 de dépôt par pulvérisation cathodique. Par ailleurs, un télémètre laser permet de mesurer en temps réel la distance H entre l'élément 109 de mesure et la partie du dispositif 104 de détection qui varie en fonction du déplacement de l'organe 108 mobile : il est ainsi possible de détecter avec précision, et le plus tôt possible, si l'objet 301 en contact avec le dispositif 104 de détection est susceptible d'entrer en collision avec le plateau 101, notamment avec sa face portant le dispositif 104 de détection.

L'élément 109 de mesure est notamment fixé sur le plateau 101, en particulier sur le support 118, notamment à un bord du plateau 101 de sorte à se trouver placé dans la cavité 110.

Selon une réalisation, l'organe 108 mobile peut comporter deux parties mobiles indépendamment l'une de l'autre et chacune associée à un élément de mesure placé dans la cavité 110, les deux éléments de mesure étant par exemple fixés respectivement à deux bords opposés du plateau 101 rejoignant le bord 114 du plateau sur lequel l'organe 108 mobile est monté à pivotement. Chaque élément de mesure est alors configuré pour mesurer une distance se modifiant lorsque la partie mobile de l'organe mobile 108 associée à cet élément de mesure se déplace. Ceci permet de localiser plus finement où se situe l'objet 301 venant en contact avec le dispositif 104 de détection en fonction de la partie mobile de l'organe 108 mobile qui s'est déplacée.

Dans le cas où l'organe 108 mobile et la pièce 111 mobile forment la cavité 110, la cavité 110 peut présenter une longueur de cavité, par exemple égale à la longueur de profilés formant respectivement l'organe 108 mobile et la pièce 111 mobile. Ici, le dispositif 104 de détection peut comporter deux éléments 116a, 116b de protection (figures 1 et 3) agencés pour fermer la cavité 110 à ses deux extrémités opposées selon sa longueur. Ceci permet d'éviter l'entrée, dans la cavité 110, de particules de poussière ou du matériau à déposer par pulvérisation par ces extrémités opposées de la cavité 110. Sur les figures 4 et 5, l'élément de protection 116a a été retiré pour visualiser l'intérieur de la cavité 110.

Il a été décrit ci-avant un élément 109 de mesure optique. Alternativement, l'élément 109 de mesure peut être mécanique ou de tout type permettant de détecter/mesurer un déplacement de l'organe 108 mobile de manière efficace lorsqu'il est soumis à un champ magnétique comme c'est le cas dans une chambre 302 permettant un dépôt par pulvérisation cathodique. Ainsi, l'utilisation d'un élément de mesure de type capacitif ou magnétique sera évitée car il ne sera pas capable de fournir une mesure précise.

Selon une réalisation particulière, le dispositif 104 de détection peut être tel que l'élément 109 de mesure réalise plusieurs mesures de la distance entre l'élément 109 de mesure et la partie du dispositif 104 de détection qui varie en fonction du déplacement de l'organe 108 mobile. Ceci permet de suivre l'évolution de la distance en vue d'évaluer si l'appui de l'objet 301 sur l'organe 108 mobile est tel que si le dispositif 100 de transport continu de se déplacer cela engendrerait un contact entre l'objet 301 et le plateau 101, et/ou entre l'objet 301 et au moins une des plaques 200. En ce sens, le dispositif 104 de détection peut être configuré pour détecter la proximité d'un objet 301 non gênant pour le plateau 101 et pour détecter la proximité d'un objet 301 susceptible d'entrer en collision avec le plateau 101.

Avantageusement, le dispositif 100 de transport comporte un dispositif 117 (visible en figure 4) de communication, notamment sans-fil, configuré pour transmettre un message lorsque le dispositif 104 de détection détecte la proximité de l'objet 301 par rapport au plateau 101. Un tel dispositif 117 de communication peut comporter un émetteur, par exemple Wi-Fi, Bluetooth ou radiofréquence, pour émettre un signal comportant le message à transmettre. Ceci permet de diffuser le message, par exemple à un automate de commande du dispositif 300 à passage pour stopper le déplacement du dispositif 100 de transport afin d'éviter le contact entre l'objet 301 et le plateau 101 ou, le cas échéant, entre l'objet 301 et au moins une des plaques 200 logées dans le dispositif 100 de transport.

L'organe 108 mobile est, de préférence, en inox ou en aluminium, ces matériaux étant notamment adaptés pour passer dans la chambre 302, notamment de dépôt de couches sur les plaques 200. Le cas échéant, et pour les mêmes raisons que l'organe 108 mobile, la pièce 111 mobile peut être en inox ou en aluminium. Notamment, le plateau 101 peut aussi être en inox ou en aluminium.

L'invention est aussi relative à une installation 1000 pour traiter des plaques 200, par exemple telle que visible en figure 6. Cette installation 1000 comporte notamment le dispositif 100 de transport pour plaques 200 tel que décrit et le dispositif 300 à passage tel que décrit. Une telle installation 1000 présente donc l'avantage de pouvoir traiter les plaques 200, par exemple en y déposant sur chacune une couche de matériau par pulvérisation cathodique, tout en permettant, le cas échéant, la détection de la proximité d'un objet 301 correspondant susceptible d'abîmer une ou plusieurs plaques 200, ou encore de polluer les plaques 200, au cours du traitement.

Il résulte de ce qui a été décrit ci-dessus qu'il peut être avantageux d'arrêter tout mouvement du dispositif 100 de transport lorsqu'un objet 301 est détecté par le dispositif 104 de détection. En ce sens, le dispositif 300 à passage comporte préférentiellement un automate 305 de commande (figure 6) du déplacement du dispositif 100 de transport dans le dispositif 300 à passage, notamment dans sa chambre 302. Par ailleurs, le dispositif 100 de transport est ici préférentiellement configuré pour transmettre un message à l'automate 305 de commande, de préférence via une connexion sans-fil, en cas de détection, par le dispositif 104 de détection, de la proximité d'un objet 301 dans le dispositif 300 à passage. Autrement dit, il y a communication du dispositif 100 de transport avec l'automate 305 de commande en cas de détection de l'objet 301 par le dispositif 104 de détection. Ainsi, l'automate 305 de commande est notamment configuré de sorte que la réception du message par l'automate 305 de commande provoque l'arrêt du déplacement du dispositif 100 de transport, ceci permettant d'éviter l'entrée en collision de l'objet 301 avec le plateau 101 et/ou de l'objet 301 avec au moins une des plaques 200. La connexion sans-fil permet ici d'éviter tout lien physique entre l'automate 305 de commande et le dispositif 100 de transport qui serait gênant lors du passage du dispositif 100 de transport dans le dispositif 300 à passage. Pour cela, l'automate 305 de commande peut comporter un dispositif 306 de communication configuré pour communiquer sans-fil avec le dispositif 117 de communication décrit ci-avant du dispositif 100 de transport. Un tel dispositif 306 de communication de l'automate 305 de commande peut comporter un récepteur, par exemple Wi-Fi, Bluetooth ou radiofréquence, pour recevoir le signal comportant le message transmis par le dispositif 117 de communication du dispositif 100 de transport.

Comme évoqué précédemment, la chambre 302 du dispositif 300 à passage peut être une chambre de dépôt d'un matériau par pulvérisation cathodique dont l'avantage est de permettre le dépôt d'oxyde conducteur transparent pour former une électrode de cellule photovoltaïque sur chacune des plaques 200 transportées par le dispositif 100 de transport.

Dans le cadre de l'installation 1000, le dispositif 104 de détection permet de détecter la proximité d'un objet 301 qui appartient alors à ce dispositif 300 à passage. Un tel objet 301 peut être un écran 303c de protection de pièces de la chambre 302.

Le dispositif 100 de transport peut aussi comporter un ou des rails 119 de guidage de son déplacement dans l'installation 1000. Chaque rail 119 est alors notamment agencé à la face inférieure 107 du plateau 101 (figure 6).

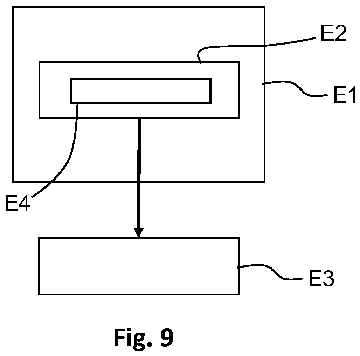

L'invention est aussi relative à un procédé de traitement de plaques 200 destinées à former des composants électroniques. Notamment, un tel procédé de traitement permet de déposer une couche d'un matériau, tel un oxyde transparent conducteur, sur chacune des plaques 200 transportées par le dispositif 100 de transport. Ici, les plaques 200 sont logées dans les logements 102 du dispositif 100 de transport, et le procédé de traitement comporte (figure 9) : une étape E1 de déplacement du dispositif 100 de transport dans le dispositif 300 à passage comportant la chambre 302 de traitement des plaques 200 ; et une étape E2 de détection de la proximité d'un objet 301 par le dispositif 104 de détection au cours de l'étape E1 de déplacement. Ceci permet notamment de savoir si au cours du traitement des plaques 200 il y a eu un risque de pollution de ces dernières.

Avantageusement, le procédé de traitement comporte (figure 9), après détection de la proximité de l'objet 301 par le dispositif 104 de détection, une étape E3 d'arrêt de l'étape E1 de déplacement du dispositif 100 de transport. Autrement dit, la détection de la proximité de l'objet 301 par le dispositif 104 de détection peut déclencher cette étape E3 d'arrêt. Cette étape d'arrêt permet d'éviter le contact entre l'objet 301 et le plateau 101 et/ou entre l'objet 301 au moins une des plaques 200.

Selon un mode de réalisation particulier du procédé de traitement, cours de l'étape E1 de déplacement, l'objet 301 vient exercer une force sur l'organe 108 mobile du dispositif 100 de transport (c'est-à-dire l'organe 108 mobile du dispositif 104 de détection) d'où il résulte un déplacement de l'organe 108 mobile modifiant la distance H mesurée par l'élément 109 de mesure du dispositif 104 de détection. Par exemple, le procédé de traitement peut comporter une étape de mesure de la distance H, par exemple à intervalles réguliers, notamment par l'élément 109 de mesure. Ici, le procédé de traitement, notamment son étape E2 de détection, comporte une étape E4 de traitement de la distance mesurée telle que :
- si la distance mesurée est supérieure ou égale à un premier seuil et est strictement inférieure à une valeur de référence représentative d'une absence d'objet 301 en contact avec l'organe 108 mobile, alors l'étape E2 de détection détecte la proximité de l'objet 301 et la mise en œuvre de l'étape E1 de déplacement continue, ceci permet de sortir le dispositif 100 de transport du dispositif 300 à passage tout en détectant la proximité de l'objet 301 qui peut alors indiquer une nécessité de réaliser une maintenance du dispositif 300 à passage,
- si la distance mesurée est inférieure ou égale à un deuxième seuil, alors le déplacement du dispositif 100 de transport est stoppé, le deuxième seuil étant strictement inférieur au premier seuil.

En fait, ici le premier seuil est choisi de sorte à détecter une proximité de l'objet 301 pour laquelle il n'y a pas besoin de stopper la production, et le deuxième seuil est choisi de sorte qu'il est représentatif d'une détection pouvant porter préjudice à la production de composants électroniques à partir des plaques 200. Par exemple, les premier et deuxième seuils et les dimensions du dispositif 104 de détection sont adaptés en fonction des besoins et du type du dispositif 300 à passage devant être traversé par le dispositif de transport.

Dans le cadre du procédé de traitement, l'élément 109 de mesure peut mesurer la distance H de manière continue, par exemple à intervalles réguliers ou non pour détecter au plus tôt une situation pour laquelle il y a un risque de collision entre l'objet 301 et le plateau 101 (cas où la distance mesurée est inférieure ou égale au deuxième seuil).

Le dispositif 100 de transport, l'installation 1000 pour traiter les plaques 200 ainsi que le procédé de traitement, trouvent chacun une application industrielle dans le cadre de la fabrication de composants électroniques tels que des cellules photovoltaïques.

## Revendications

1. Dispositif (100) de transport pour plaques (200) destinées à former des composants électroniques, ledit dispositif (100) de transport comportant un plateau (101), le plateau (101) comportant des logements (102) pour les plaques (200), **caractérisé en ce qu'**il comporte un dispositif (104) de détection de proximité d'objet (301) par rapport au plateau (101), ledit dispositif (104) de détection étant configuré pour détecter la proximité d'un objet (301) lorsque l'objet (301) exerce une force sur le dispositif (104) de détection.

2. Dispositif (100) de transport selon la revendication 1, **caractérisé en ce que** le dispositif (104) de détection comporte un organe (108) mobile configuré pour se déplacer lorsque l'objet (301) exerce ladite force sur l'organe (108) mobile, et **en ce que** le dispositif (104) de détection est configuré pour détecter un déplacement de l'organe (108) mobile représentatif d'une détection de la proximité de l'objet (301) par rapport au plateau (101).

3. Dispositif (100) de transport selon l'une quelconque des revendications 1 à 2, **caractérisé en ce que** le dispositif (104) de détection comporte une cavité (110) à géométrie variable et un élément (109) de mesure d'une distance (H), le dispositif (104) de détection étant configuré pour qu'une modification la géométrie de la cavité (110), provoquée lorsque l'objet (301) exerce la force sur le dispositif (104) de détection, induit une modification de la distance (H).

4. Dispositif (100) de transport selon la revendication précédente, **caractérisé en ce que** l'élément (109) de mesure est configuré pour réaliser une mesure optique de la distance (H).

5. Dispositif (100) de transport selon la revendication 2 et l'une quelconque des revendications 3 à 4, **caractérisé en ce que** le dispositif (104) de détection est configuré de telle sorte que le déplacement de l'organe (108) mobile provoque la modification de la géométrie de la cavité (110).

6. Dispositif (100) de transport selon la revendication 2 et l'une quelconque des revendications 3 à 5, **caractérisé en ce que** le dispositif (104) de détection comporte une pièce (111) mobile, la pièce (111) mobile et l'organe (108) mobile délimitant la cavité (110) à géométrie variable.

7. Dispositif (100) de transport selon la revendication précédente, **caractérisé en ce que** le dispositif (104)de détection comporte un dispositif (112, 113) de rappel sollicitant la pièce (111) mobile et l'organe (108) mobile chacun vers une position associée à une configuration déployée de la cavité (110), et **en ce que** l'organe (108) mobile et la pièce (111) mobile sont configurés de sorte à se rabattre vers le plateau (101) par glissement de l'organe (108) mobile sur la pièce (111) mobile lorsque l'organe (108) mobile est mis en mouvement par l'objet (301).

8. Dispositif (100) de transport selon la revendication 2 ou la revendication 2 et l'une quelconque des revendications précédentes, **caractérisé en ce que** le dispositif (104)de détection comporte une butée (115) de limitation du déplacement de l'organe (108) mobile.

9. Dispositif (100) de transport selon l'une quelconque des revendications précédentes, **caractérisé en ce que** le plateau (101) comporte un bord (114), et **en ce que** le dispositif (104) de détection s'étend le long de ce bord (114), et de préférence tout du long de ce bord (114).

10. Dispositif (100) de transport selon l'une quelconque des revendications précédentes, **caractérisé en ce qu'**il comporte un dispositif (117) de communication configuré pour transmettre un message lorsque le dispositif (104) de détection détecte la proximité de l'objet (301) par rapport au plateau (101).

11. Installation (1000) pour traiter des plaques (200), **caractérisée en ce qu'**elle comporte :
- un dispositif (100) de transport pour plaques (200) selon l'une quelconque des revendications 1 à 10,
- un dispositif (300) à passage comportant une chambre (302) de traitement des plaques (200) pour traiter les plaques (200) lors du passage du dispositif (100) de transport au travers du dispositif (300) à passage.

12. Installation (1000) selon la revendication précédente, **caractérisée en ce que** :
- le dispositif (300) à passage comporte un automate (305) de commande du déplacement du dispositif (100) de transport dans le dispositif (300) à passage,
- le dispositif (100) de transport est configuré pour transmettre un message à l'automate (305) de commande en cas de détection, par le dispositif (104) de détection, de la proximité d'un objet (301) dans le dispositif (300) à passage.

13. Procédé de traitement de plaques (200) destinées à former des composants électroniques, **caractérisé en ce que** les plaques (200) sont logées dans les logements (102) d'un dispositif (100) de transport selon l'une quelconque des revendications 1 à 10, et **en ce que** ledit procédé de traitement comporte :
- une étape (E1) de déplacement du dispositif (100) de transport dans un dispositif (300) à passage comportant une chambre (302) de traitement des plaques (200),
- une étape (E2) de détection de la proximité d'un objet (301) par le dispositif (104) de détection au cours de l'étape (E1) de déplacement.

14. Procédé de traitement selon la revendication précédente, **caractérisé en ce qu'**il comporte, après détection de la proximité de l'objet (301) par le dispositif (104) de détection, une étape (E3) d'arrêt de l'étape (E1) de déplacement du dispositif (100) de transport.

15. Procédé de traitement selon la revendication 13, **caractérisé en ce qu'**au cours de l'étape (E1) de déplacement, l'objet (301) vient exercer une force sur un organe (108) mobile du dispositif (100) de transport d'où il résulte un déplacement de l'organe (108) mobile modifiant une distance mesurée par un élément (109) de mesure du dispositif (104) de détection, et **en ce que** le procédé de traitement comporte une étape (E4) de traitement de la distance mesurée telle que :
- si la distance mesurée est supérieure ou égale à un premier seuil et est strictement inférieure à une valeur de référence représentative d'une absence d'objet en contact avec l'organe (108) mobile, alors l'étape (E2) de détection détecte la proximité de l'objet (301) et la mise en œuvre de l'étape (E1) de déplacement continue,
- si la distance mesurée est inférieure ou égale à un deuxième seuil, alors le déplacement du dispositif (100) de transport est stoppé, le deuxième seuil étant strictement inférieur au premier seuil.
